# EUROPEAN PATENT APPLICATION

(11) **EP 4 180 176 A1**
(43) Date of publication of application: **17.05.2023**
(21) Application number: 21837337.1
(22) Date of filing: 07.07.2021
(51) Int. Cl.: B24B 7/22, C09J 201/00, B24B 41/06, H01L 21/304, C09J 7/29, C09J 7/38

(54) **PROTECTIVE FILM AND BACK GRINDING METHOD FOR SEMICONDUCTOR WAFER**

(30) Priority: 10.07.2020 JP 2020119483
(71) Applicant: Mitsui Chemicals Tohcello, Inc., Tokyo 101-8485 (JP)
(72) Inventor: HAYASHISHITA, Eiji, Nagoya-shi, Aichi 457-0801 (JP)
(74) Representative: Hoffmann Eitle
(86) International application number: PCT/JP2021/025692
(87) International publication number: WO 2022/009940

(57) **Abstract**

Provided are a protective film and a back grinding method for a semiconductor wafer, which can suppress occurrence of suction defect. A protective film 30 is a film that protects a surface 11 of a semiconductor wafer 10 on which a circuit is formed when a back surface 12 of the semiconductor wafer 10 is ground in a state where the surface 11 of the semiconductor wafer 10 is sucked to a fixture 41. The protective film 30 has a pressure-sensitive adhesive layer 33, a base material layer 31, and an auxiliary layer 32. The pressure-sensitive adhesive layer 33 is a layer to be stuck to the semiconductor wafer 10, the auxiliary layer 32 is a layer to be contact to the fixture 41, and the semiconductor wafer 10 is a semiconductor wafer having a level difference 13 on an outer peripheral edge of the surface 11 on which the circuit is formed.

## Description

### TECHNICAL FIELD

The present invention relates to a protective film for protecting a circuit when a surface of a semiconductor wafer on which the circuit is formed is sucked to a fixture, and a back grinding method for a semiconductor wafer using the protective film.

### BACKGROUND ART

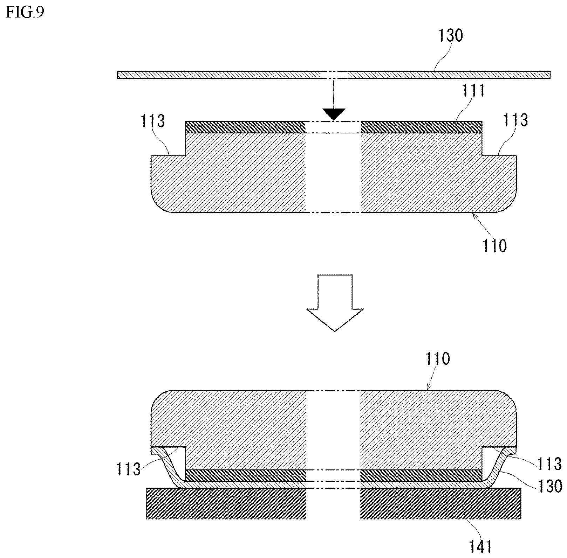

At the time of manufacturing a semiconductor component, a circuit and the like are formed on a front surface side of a semiconductor wafer, and then processing of grinding a back surface side is performed to reduce the thickness of the semiconductor wafer. In a back grinding method of grinding the back surface side, in a semiconductor wafer 110, a protective film 130 is stuck to a front surface 111 on which the circuit and the like are formed (see Fig. 9). The front surface 111 of the semiconductor wafer 110 is sucked to a fixture 141 via the protective film 130. The protective film 130 covers the circuit and the like to protect the circuit and the like.

As a technique related to the protective film and the back grinding method described above, Patent Literature 1 is disclosed. Patent Literature 1 includes a cutting step (trimming process) of cutting and removing at least a film layer on a chamfered portion in a circular shape by rotating a semiconductor wafer having the film layer formed on a surface and a chamfered portion formed on an outer peripheral side surface while feeding a cutting blade to cut into an outer peripheral edge from the surface of the semiconductor wafer.

The semiconductor wafer 110 subj ected to the trimming process has a level difference 113 on an outer peripheral edge of the front surface 111. Thus, the fixture 141 that sucks the semiconductor wafer 110 is designed in consideration of the level difference 113.

### CITATIONS LIST

### PATENT LITERATURE

Patent Literature 1: JP 2012-43 825 A

### SUMMARY OF INVENTION

### TECHNICAL PROBLEMS

It has been found that the semiconductor wafer 110 having the level difference 113 as described above may cause suction defect such as vacuum leakage in the fixture 141. For example, in the case of a trimming process, this suction defect is considered to occur due to variations in the size and shape of the level difference 113 due to a limit of processing accuracy and the like.

The present invention has been made in view of the above problems, and an object of the present invention is to provide a protective film and a back grinding method for a semiconductor wafer, which can suppress occurrence of suction defect.

### SOLUTIONS TO PROBLEMS

As a means for solving the above problems, the present invention is as follows.
[1] The invention according to claim 1 is a protective film that protects a surface of a semiconductor wafer on which a circuit is formed when a back surface of the semiconductor wafer is ground in a state where the surface of the semiconductor wafer on which the circuit is formed is sucked to a fixture, the protective film including:
   a pressure-sensitive adhesive layer, a base material layer, and an auxiliary layer, wherein
   the pressure-sensitive adhesive layer is a layer to be stuck to the semiconductor wafer,
   the auxiliary layer is a layer to be contact to the fixture, and
   the semiconductor wafer has a level difference on an outer peripheral edge of the surface on which the circuit is formed.
[2] An invention described in claim 2 is characterized in that in the invention described in claim 1, the auxiliary layer is a layer having a tensile elastic modulus of 5 MPa or more and 150 MPa or less at a temperature of 25°C or higher and 35°C or lower.
[3] An invention described in claim 3 is characterized in that in the invention described in claim 1 or 2, the auxiliary layer contains one or more than one selected from the group consisting of an ethylene-vinyl acetate copolymer, a polyolefin-based elastomer, a styrene-based elastomer, a polyester-based elastomer, and a polyamide-based elastomer.
[4] An invention described in claim 4 is characterized in that in the invention described in any one of claims 1 to 3, a thickness of the auxiliary layer is 100 µm or more and 500 µm or less.
[5] An invention described in claim 5 is characterized in that in the invention described in any one of claims 1 to 4, the base material layer is a layer having a tensile elastic modulus of 5000 MPa or less at a temperature of 25°C or higher and 35°C or lower.
[6] An invention described in claim 6 is characterized in that in the invention described in any one of claims 1 to 5, the base material layer contains one or more than one selected from the group consisting of polyester and polyamide.
[7] An invention described in claim 7 is characterized in that in the invention described in any one of claims 1 to 6, a thickness of the base material layer is 10 µm or more and 200 µm or less.
[8] The invention according to claim 8 includes:
   a sticking step of sticking a protective film to a surface of a semiconductor wafer on which a circuit is formed;
   a sucking step of sucking the semiconductor wafer to the fixture, via the protective film, with the protective film interposed between the semiconductor wafer and the fixture sucking the semiconductor wafer; and
   a grinding step of grinding a back surface of the semiconductor wafer in a state where the semiconductor wafer is sucked to the fixture via the protective film, wherein
   the protective film includes a pressure-sensitive adhesive layer, a base material layer, and an auxiliary layer,
   the pressure-sensitive adhesive layer is a layer to be stuck to the semiconductor wafer,
   the auxiliary layer is a layer to be contact to the fixture, and
   the semiconductor wafer has a level difference on an outer peripheral edge of the surface on which the circuit is formed.
[9] An invention described in claim 9 is characterized in that in the invention described in claim 8, the auxiliary layer is a layer having a tensile elastic modulus of 5 MPa or more and 150 MPa or less at a temperature of 25°C or higher and 35°C or lower.
[10] An invention described in claim 10 is characterized in that in the invention described in claim 8 or 9, the auxiliary layer contains one or more than one thermoplastic materials selected from the group consisting of an ethylene-vinyl acetate copolymer, a polyolefin-based elastomer, a styrene-based elastomer, a polyester-based elastomer, and a polyamide-based elastomer.
[11] An invention described in claim 11 is characterized in that in the invention described in any one of claims 8 to 10, a thickness of the auxiliary layer is 100 µm or more and 500 µm or less.
[12] An invention described in claim 12 is characterized in that in the invention described in any one of claims 8 to 11, the base material layer is a layer having a tensile elastic modulus of 5000 MPa or less at a temperature of 25°C or higher and 35°C or lower.
[13] An invention described in claim 13 is characterized in that in the invention described in any one of claims 8 to 12, the base material layer contains one or more than one thermoplastic materials selected from the group consisting of polyester and polyamide.
[14] An invention described in claim 14 is characterized in that in the invention described in any one of claims 8 to 13, a thickness of the base material layer is 10 µm or more and 200 µm or less.

### ADVANTAGEOUS EFFECTS OF INVENTION

According to the protective film and the back grinding method for a semiconductor wafer of the present invention, occurrence of suction defect can be suppressed.

### BRIEF DESCRIPTION OF DRAWINGS

Fig. 1 is an enlarged front cross-sectional view for explaining a protective film of the present invention.
Fig. 2 is a front cross-sectional view for explaining a semiconductor wafer according to the present invention.
Fig. 3 is a front cross-sectional view for explaining a trimming process of the semiconductor wafer according to the present invention.
Fig. 4 is a front cross-sectional view for explaining a sticking step in a back grinding method for the semiconductor wafer of the present invention.
Fig. 5 is a front cross-sectional view for explaining a sucking step in the back grinding method for the semiconductor wafer of the present invention.
Fig. 6 is a front cross-sectional view for explaining a grinding step in the back grinding method for the semiconductor wafer of the present invention.
Fig. 7 is a front cross-sectional view for explaining a grinding step of a semiconductor wafer according to another embodiment of the present invention.
Fig. 8 is a front cross-sectional view for explaining the semiconductor wafer of another embodiment according to the present invention.
Fig. 9 is a front cross-sectional view for explaining a conventional method of sucking the semiconductor wafer.

### DESCRIPTION OF EMBODIMENT

Hereinafter, the present invention will be described with reference to the drawings. The particulars shown herein are by way of example and for purposes of illustrative discussion of the embodiments of the present invention only and are presented in the cause of providing what is believed to be the most useful and readily understood description of the principles and conceptual aspects of the present invention. In this regard, no attempt is made to show structural details of the present invention in more detail than is necessary for the fundamental understanding of the present invention, the description is taken with the drawings making apparent to those skilled in the art how the forms of the present invention may be embodied in practice.

### [1] Protective film

A protective film of the present invention protects a surface of a semiconductor wafer on which a circuit is formed when a back surface of the semiconductor wafer is ground in a state where the surface of the semiconductor wafer on which the circuit is formed is sucked to a fixture.

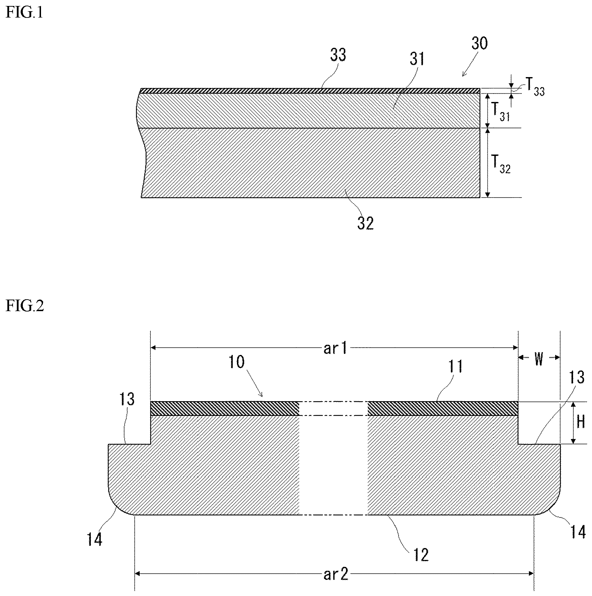

The protective film has a pressure-sensitive adhesive layer, a base material layer, and an auxiliary layer (see Fig. 1).

The pressure-sensitive adhesive layer is a layer stuck to the semiconductor wafer.

The auxiliary layer is a layer to be contact to the fixture.

The semiconductor wafer in the present invention is a semiconductor wafer having a level difference on an outer peripheral edge of the surface on which the circuit is formed.

Since the semiconductor wafer having such a shape has the level difference on the outer peripheral edge, when the back surface is ground, a sucking area of the surface (on which the circuit is formed and to which the protective film is stuck) sucked to the fixture may be reduced as compared with the semiconductor wafer having no level difference on the outer peripheral edge.

Thus, since the semiconductor wafer in the present invention has the level difference on the outer peripheral edge of the surface on which the circuit is formed, the semiconductor wafer can also be said to be a semiconductor wafer in which the sucking area of the surface (on which the circuit is formed) sucked to the fixture is reduced.

Hereinafter, in the semiconductor wafer, the surface on which the circuit is formed is also referred to as a "non-ground surface", and a surface to be ground by reduction in thickness according to a back grinding method is also referred to as a "ground surface".

Specifically, as shown in Fig. 1, the protective film 30 includes a base material layer 31, an auxiliary layer 32 provided on one surface side (lower surface side in Fig. 1) of the base material layer 31, and a pressure-sensitive adhesive layer 33 provided on the other surface side (upper surface side in Fig. 1) of the base material layer 31.

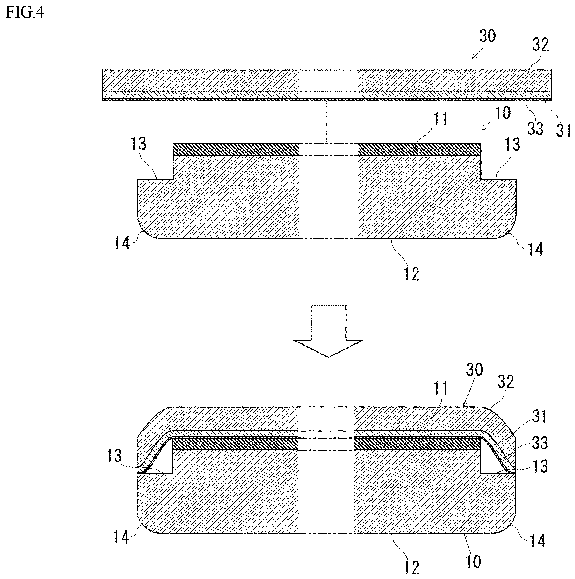

The protective film 30 is used in a sticking step according to the back grinding method with the pressure-sensitive adhesive layer 33 side facing a non-ground surface 11 of a semiconductor wafer 10. The pressure-sensitive adhesive layer 33 is stuck to the non-ground surface 11 of the semiconductor wafer 10 (see Fig. 4).

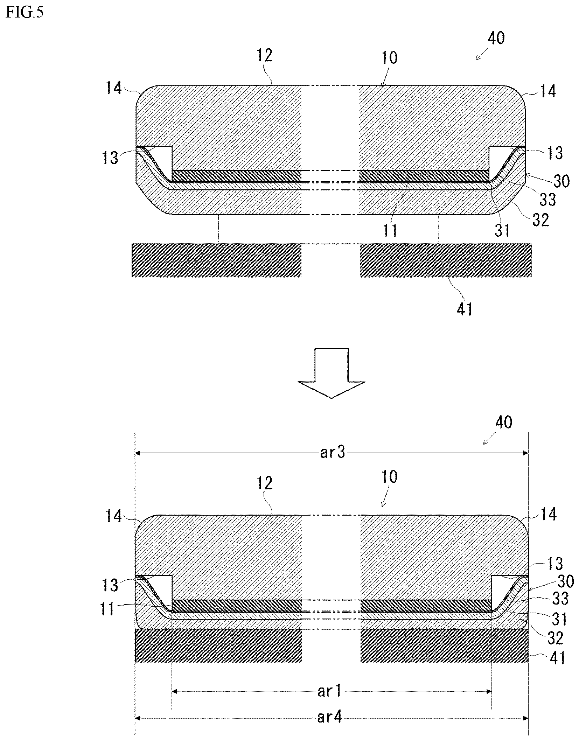

The protective film 30 is used in a sucking step according to the back grinding method with the auxiliary layer 32 side facing a fixture 41. The auxiliary layer 32 is contact to the fixture 41 and sucked to the fixture 41 (see Fig. 5).

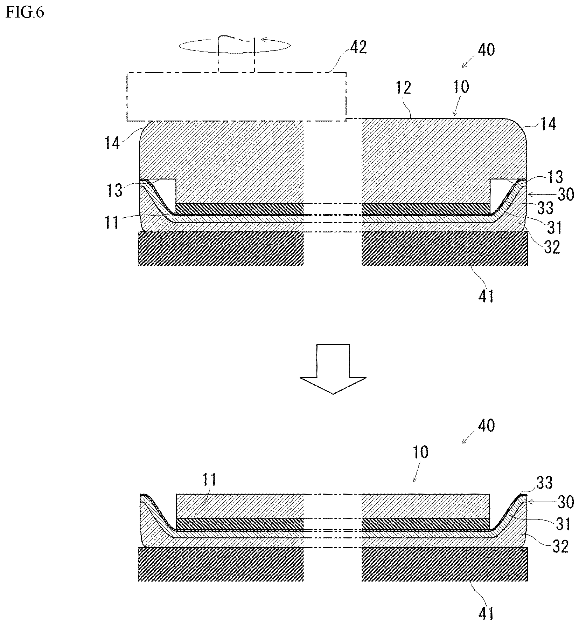

The auxiliary layer 32 corresponds to a surface shape of the non-ground surface 11 of the semiconductor wafer 10 and a surface shape of the fixture 41, and elastically deforms following these shapes. That is, the auxiliary layer 32 elastically deforms to assist the suction of the semiconductor wafer 10 to the fixture 41 (see Fig. 6).

In addition, the base material layer 31 of the protective film 30 is stuck to the non-ground surface 11 of the semiconductor wafer 10 by the pressure-sensitive adhesive layer 33 in the sticking step of the back grinding method. The base material layer 31 covers the non-ground surface 11 of the semiconductor wafer 10 and protects a circuit formed on the non-ground surface 11 in a grinding step of the back grinding method.

The shape of the protective film 30 is not particularly limited. The protective film 30 can have, for example, a circular shape, a square shape, or another shape in plan view.

The average thickness of the protective film 30 is not particularly limited. Specifically, the average thickness of the protective film 30 can be preferably 150 to 1000 µm, more preferably 175 to 950 µm or more, and still more preferably 200 to 750 µm.

The average thickness is an average value of an actually measured thicknesses of the film at 10 points selected so as to be separated from each other by 2 cm or more.

Hereinafter, each layer of the protective film 30 will be described.

### (1) Base material layer

The base material layer 31 is a layer provided for the purpose of protecting the circuit formed on the non-ground surface 11 of the semiconductor wafer 10. The base material layer 31 is a layer that improves the handleability, mechanical properties, and the like of the protective film 30.

The material used for the base material layer 31 is not particularly limited as long as it has mechanical strength capable of withstanding an external force in the grinding step of the back grinding method.

Usually, a synthetic resin film is used as a material of the base material layer 31.

Examples of the synthetic resin include polyolefins such as polyethylene, polypropylene, poly(4-methyl-1-pentene), and poly(1-butene); ethylene-vinyl acetate copolymer, polyesters such as polyethylene terephthalate and polybutylene terephthalate; polyamides such as nylon-6, nylon-66, and polymethaxylene adipamide; polyacrylate; polymethacrylate; polyvinyl chloride; polyetherimide; polyacrylonitrile; polycarbonate; polystyrene; ionomer; polysulfone; polyethersulfone; and one or two or more thermoplastic resins selected from polyphenylene ether and the like.

The base material layer 31 preferably contains one or more than one selected from the group consisting of polyester and polyamide among the synthetic resins described above. When these synthetic resins are contained, good handleability of the protective film 30 can be obtained.

An additive can be added to the synthetic resin described above. Examples of the additive include a plasticizer, a softener (such as mineral oil), a filler (such as carbonate, sulfate, titanate, silicate, oxide (titanium oxide, magnesium oxide), silica, talc, mica, clay, and fiber filler), an antioxidant, a light stabilizer, an antistatic agent, a lubricant, and a colorant. These additives may be used singly or in combination of two or more kinds thereof.

Films used as the materials of the base material layer 31 may be stretched or not. As the film, any stretched film such as an unstretched film, a uniaxially stretched film, or a biaxially stretched film can be used. In particular, the stretched film is useful from the viewpoint of improving mechanical strength.

As the film described above, both a single layer film and a multilayer film having a plurality of layers can be used.

A surface-treated film is preferably used for the base material layer 31. In this case, adhesiveness with the auxiliary layer 32 and the like can be improved. Specific examples of the surface treatment include a corona treatment, a plasma treatment, an undercoating treatment, and a primer coating treatment.

The thickness of the base material layer 31 is not particularly limited. A thickness T₃₁ (see Fig. 1) of the base material layer 31 is preferably 10 to 200 µm, more preferably 20 to 150 µm, and still more preferably 30 to 100 µm. The range of the thickness is based on the viewpoint that the base material layer 31 can obtain good characteristics.

Here, a tensile elastic modulus of the base material layer 31 and the auxiliary layer 32 is obtained by reading data at each temperature from data obtained by measuring from 25°C to 35°C with a dynamic viscoelasticity measuring device (DMA). In measurement conditions, a sample size is 10 mm in width, a length between chucks is 20 mm, a frequency is 1 Hz, and a temperature rise rate is 5°C/min.

Hereinafter, regarding the tensile elastic modulus of the base material layer 31, a value at 25°C is E'₃₁ (25), a value at 35°C is E'₃₁ (35), and a value at each temperature of 25°C or higher and 35°C or lower is E'₃₁ (t).

Regarding the tensile elastic modulus of the auxiliary layer 32, a value at 25°C is E'₃₂ (25), a value at 35°C is E'₃₂ (35), and a value at each temperature of 25°C or higher and 35°C or lower is E'₃₂ (t).

The tensile elastic modulus of the base material layer 31 is usually E'₃₁ (t) ≤ 5000 MPa. That is, in the temperature range of 25°C ≤ t ≤ 35°C, the tensile elastic modulus of the base material layer 31 is always 5000 MPa or less. Therefore, E'₃₁ (25) ≤ 5000 MPa and E'₃₁ (35) ≤ 5000 MPa are satisfied.

E'₃₁ (t) > E'₃₂ (t) is typically satisfied. That is, in the temperature range of 25°C ≤ t ≤ 35°C, the tensile elastic modulus of the base material layer 31 is always higher than the tensile elastic modulus of the auxiliary layer 32. Although a degree of the height is not limited, E'₃₁ (t) is preferably higher than E'₃₂ (t) by 20 to 4850 MPa, and more preferably higher by 700 to 4850 MPa.

Therefore, at t = 25°C, a difference (E'₃₁ (25) - E'₃₂ (25)) between the tensile elastic modulus of the base material layer 31 and the tensile elastic modulus of the auxiliary layer 32 is preferably 20 MPa ≤ E'₃₁ (25) - E'₃₂ (25) ≤ 4850 MPa, and more preferably 700 MPa ≤ E'₃₁ (25) - E'₃₂ (25) ≤ 4850 MPa.

Similarly, at t = 35°C, a difference (E'₃₁ (35) - E'₃₂ (35)) between the tensile elastic modulus of the base material layer 31 and the tensile elastic modulus of the auxiliary layer 32 is preferably 20 MPa ≤ E'₃₁ (35) - E'₃₂ (35) ≤ 4850 MPa, and more preferably 700 MPa ≤ E'₃₁ (35) - E'₃₂ (35) ≤ 4850 MPa.

The tensile elastic modulus of the base material layer 31 and the tensile elastic modulus of the auxiliary layer 32 have the relationship described above.

At the time of suction of the semiconductor wafer 10 to the fixture 41, since the tensile elastic modulus of the base material layer 31 is always higher than the tensile elastic modulus of the auxiliary layer 32, in order to protect the circuit of the non-ground surface 11 of the semiconductor wafer 10, a shape covering the non-ground surface 11 is maintained (see Fig. 5).

On the other hand, since the tensile elastic modulus of the auxiliary layer 32 is always lower than the tensile elastic modulus of the base material layer 31, the auxiliary layer 32 elastically deforms. With respect to the elastic deformation of the auxiliary layer 32, a back layer portion on the base material layer 31 side has a shape following the base material layer 31, and a front layer portion on the fixture 41 side has a shape following the surface shape of the fixture 41 (see Fig. 5).

### (2) Auxiliary layer

The auxiliary layer 32 is a layer provided for the purpose of assisting the suction of the semiconductor wafer 10 to the fixture 41 in the sucking step of the back grinding method.

Specifically, the auxiliary layer 32 is a layer that can be elastically deformed according to both the surface shape of the semiconductor wafer 10 having the level difference 13 and the surface shape of the fixture 41 (see Fig. 5). Then, the elastically deformed auxiliary layer 32 assists the suction of the semiconductor wafer 10 to the fixture 41.

When the tensile elastic modulus of the auxiliary layer 32 is lowered, flexibility is enhanced. In this case, followability of the auxiliary layer 32 with respect to the surface shape of the non-ground surface 11 of the semiconductor wafer 10 and the surface shape of the fixture 41 (chuck table or the like) can be improved.

Hardness of the auxiliary layer 32 increases when the tensile elastic modulus is increased. In this case, sticking of the auxiliary layer 32 to the fixture 41 (chuck table or the like) is suppressed, and detachability between the auxiliary layer 32 and the fixture 41 can be improved.

The tensile elastic modulus of the auxiliary layer 32 is preferably 5 MPa ≤ E'₃₂ (t) < 150 MPa. That is, in the temperature range of 25°C ≤ t ≤ 35°C, the tensile elastic modulus of the auxiliary layer 32 is 5 MPa or more and 150 MPa or less. In this case, the auxiliary layer 32 can exhibit sufficient elasticity (dynamic stretchability) under an environmental temperature at which the back grinding method is performed.

This tensile elastic modulus is more preferably 6 MPa ≤ E'₃₂ (t) ≤ 120 MPa. The tensile elastic modulus is still more preferably 7 MPa ≤ E'₃₂ (t) ≤ 80 MPa. The tensile elastic modulus is particularly preferably 8 MPa ≤ E'₃₂ (t) ≤ 60 MPa. The tensile elastic modulus is most preferably 9 MPa ≤ E'₃₂ (t) ≤ 45 MPa.

The material used for the auxiliary layer 32 is not particularly limited. The material of the auxiliary layer 32 is preferably a resin, and among the resins, a resin having sufficient elasticity (dynamic stretchability) is more preferable, and a resin containing a thermoplastic material having elastomeric properties is particularly preferable.

The thermoplastic material having elastomeric properties may be composed of a block copolymer of a hard segment with a soft segment, may be composed of a polymer alloy of a hard polymer and a soft polymer, or may have their properties.

Examples of the thermoplastic material include ethylene-vinyl acetate copolymers, polyolefin-based elastomers, styrene-based elastomers, polyester-based elastomers, and polyamide-based elastomers. These materials may be used singly or in combination of two or more kinds thereof.

When the material of the auxiliary layer 32 is a resin containing the thermoplastic material described above, a ratio of the thermoplastic material is preferably 40 to 100% by mass, more preferably 60 to 100% by mass, and still more preferably 80 to 100% by mass with respect to the entire resin constituting the auxiliary layer 32. That is, the resin constituting the auxiliary layer 32 may be made only of the thermoplastic material described above.

Among the thermoplastic materials described above, the ethylene-vinyl acetate copolymer is particularly preferable because the elasticity can be adjusted according to the content of vinyl acetate. The content of vinyl acetate in the ethylene-vinyl acetate copolymer is preferably 4 to 30% by mass, more preferably 5 to 25% by mass, and still more preferably 8 to 20% by mass when the total mass of the polymer is 100% by mass.

The thickness of the auxiliary layer 32 is not particularly limited. A thickness T₃₂ (see Fig. 1) of the auxiliary layer 32 is preferably 100 to 500 µm, more preferably 100 to 400 µm, and still more preferably 100 to 250 µm. The range of the thickness is based on the viewpoint of maintaining a margin to the extent that elastic deformation can be sufficiently performed.

A thickness T₃₂ of the auxiliary layer 32 is usually 1.0 times or more (H ≤ T₃₂), preferably 1.5 times or more (1.5 × H ≤ T₃₂), and more preferably 2.0 times or more (2.0 × H ≤ T₃₂) as compared with the height H (see Fig. 2) of the level difference 13 in a thickness direction of the semiconductor wafer 10.

### (3) Pressure-sensitive adhesive layer

The pressure-sensitive adhesive layer 33 is a layer provided for the purpose of being stuck to the non-ground surface 11 of the semiconductor wafer 10 in the sticking step according to the back grinding method.

Specifically, the pressure-sensitive adhesive layer 33 can be formed by applying or stacking a pressure-sensitive adhesive agent and the like onto a surface (upper surface in Fig. 1) of the base material layer 31 on the non-ground surface 11 side.

The pressure-sensitive adhesive agent and the like used for the pressure-sensitive adhesive layer 33 are not particularly limited.

Examples of the pressure-sensitive adhesive agent include (meth)acrylic pressure-sensitive adhesives, silicone-based pressure-sensitive adhesives, urethane-based pressure-sensitive adhesives, rubber-based pressure-sensitive adhesives, energy ray-curable pressure-sensitive adhesives, and acryl-based, epoxy-based and silicone-based adhesives.

An adhesive force of the pressure-sensitive adhesive layer 33 is not particularly limited.

The adhesive force is preferably 0.1 to 10 N/25 mm. The adhesive force is more preferably 0.2 to 9 N/25 mm, and still more preferably 0.3 to 8 N/25 mm.

The range of the adhesive force is based on the viewpoint that remnants of glue on the semiconductor wafer can be suppressed at the time of peeling while securing good adhesiveness with the semiconductor wafer.

This adhesive force is an adhesive force to a silicon wafer measured in accordance with JIS Z 0237. Specifically, the adhesive force is a measurement value at the time of sticking to a surface of the silicon wafer under an environment of a temperature of 23°C and a relative humidity of 50%, leaving for 60 minutes, and then peeling off from the surface of the silicon wafer.

The thickness of the pressure-sensitive adhesive layer 33 is not particularly limited.

A thickness T₃₃ (see Fig. 1) of the pressure-sensitive adhesive layer 33 is preferably 1 to 50 µm, more preferably 2 to 45 µm, and still more preferably 3 to 40 µm. The range of the thickness is based on the viewpoint of capable of peeling off without remnants of glue while exerting a suitable adhesive force.

The pressure-sensitive adhesive layer 33 of the protective film 30 may be provided on a surface of the base material layer 31 on the non-ground surface 11 side at the time of being stuck to the semiconductor wafer 10.

For example, a laminate of the base material layer 31 and the auxiliary layer 32 is prepared in advance, a pressure-sensitive adhesive agent and the like are applied or stacked on the laminate or the semiconductor wafer 10 immediately before the laminate is stuck to the semiconductor wafer 10, and the laminate and the semiconductor wafer 10 are bonded together, whereby the pressure-sensitive adhesive layer 33 can be formed.

### (4) Other layers

The protective film 30 is not limited to the configuration having the layers described above, and may have a configuration having other layers.

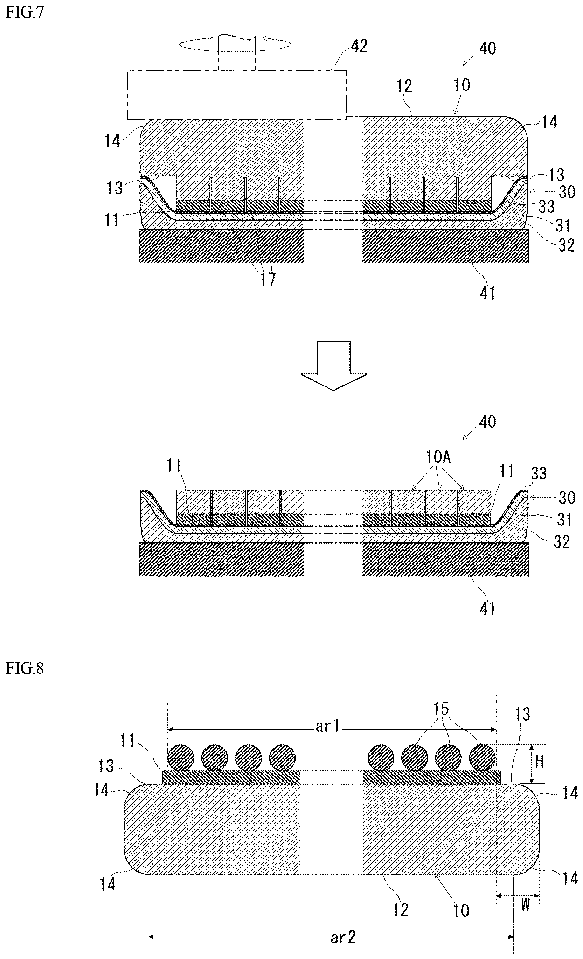

As another layer, for example, in the case of the semiconductor wafer 10 having a bump 15 illustrated in Fig. 8, an uneven absorption layer that absorbs an uneven shape formed by the bump 15 can be cited.

The uneven absorption layer can be stacked and formed on one surface of the base material layer 31 on the non-ground surface 11 side, particularly between the base material layer 31 and the pressure-sensitive adhesive layer 33. The material of the uneven absorption layer is not particularly limited as long as it has uneven absorbability by exhibiting fluidity or plasticity. Examples of the material include an acrylic resin, an olefin resin, and an ethylene-polar monomer copolymer.

The thickness of the uneven absorption layer is not particularly limited as long as the uneven absorption layer can exhibit the uneven absorbability with respect to the uneven shape formed by the bump 15. The thickness is preferably 20 µm or more, more preferably 80 µm or more, and still more preferably 170 µm or more.

A layer having the same configuration as the auxiliary layer 32 can be provided on one surface of the base material layer 31 on the non-ground surface 11 side, particularly between the base material layer 31 and the pressure-sensitive adhesive layer 33. In this case, the protective film 30 can prevent warpage of the stuck semiconductor wafer 10.

In addition, examples of the other layer include an interfacial strength improving layer that improves interfacial strength with the pressure-sensitive adhesive layer 33, a migration prevention layer that suppresses migration of a low molecular weight component to the surface of the pressure-sensitive adhesive layer 33, and an antistatic layer that prevents electrification of the protective film 30.

The other layers described above may be used singly or in combination of two or more kinds thereof.

### [2] Semiconductor wafer

The semiconductor wafer to be used in the present invention is used for manufacturing a semiconductor component, and is not particularly limited in material and shape as long as a circuit is formed on one surface (non-ground surface) of the semiconductor wafer. Usually, the semiconductor wafer is formed in a disk shape using silicon as a material (see Fig. 2).

The semiconductor wafer is reduced in thickness by grinding the back surface (ground surface) opposite to the surface (non-ground surface) on which the circuit is formed.

The protective film of the present invention is used in a back grinding method related to reduction in thickness of the semiconductor wafer. As the semiconductor wafer using this protective film, a semiconductor wafer having no level difference on the outer peripheral edge of the surface (non-ground surface) on which a circuit is formed can be used; however, the semiconductor wafer can also be suitably used for a semiconductor wafer having a level difference on the outer peripheral edge of the surface (non-ground surface) on which a circuit is formed.

That is, when the back surface of the semiconductor wafer is ground, a protective film is stuck to the non-ground surface in order to protect the non-ground surface. In the semiconductor wafer to which the protective film is stuck, the surface (non-ground surface) side to which the protective film is stuck is fixed to a fixture by vacuum suction or the like.

When the protective film is stuck to the non-ground surface of the semiconductor wafer and fixed to the fixture, the semiconductor wafer having a level difference on the outer peripheral edge of the non-ground surface may have a smaller sucking area of the non-ground surface to the fixture than the semiconductor wafer having no level difference on the outer peripheral edge of the non-ground surface. As described above, the protective film of the present invention can also be suitably used for a semiconductor wafer having a level difference on the outer peripheral edge of the surface (non-ground surface) on which a circuit is formed, and having a reduced sucking area of the non-ground surface to the fixture.

Thus, since the semiconductor wafer in the present invention has the level difference on the outer peripheral edge of the surface on which the circuit is formed, the semiconductor wafer can also be said to be a semiconductor wafer in which the sucking area of the surface (on which the circuit is formed) sucked to the fixture is reduced.

Specifically, the semiconductor wafer 10 is formed in a plate shape as shown in Fig. 2. A circuit is formed on the non-ground surface 11 of the semiconductor wafer 10. The semiconductor wafer 10 is reduced to a desired thickness by grinding the ground surface 12 (see Fig. 6).

As shown in Fig. 7, the present invention can also be used for grinding the ground surface 12 in DBG (Dicing Befor Griding) or SDBG (Stealth Dicing Befor Griding).

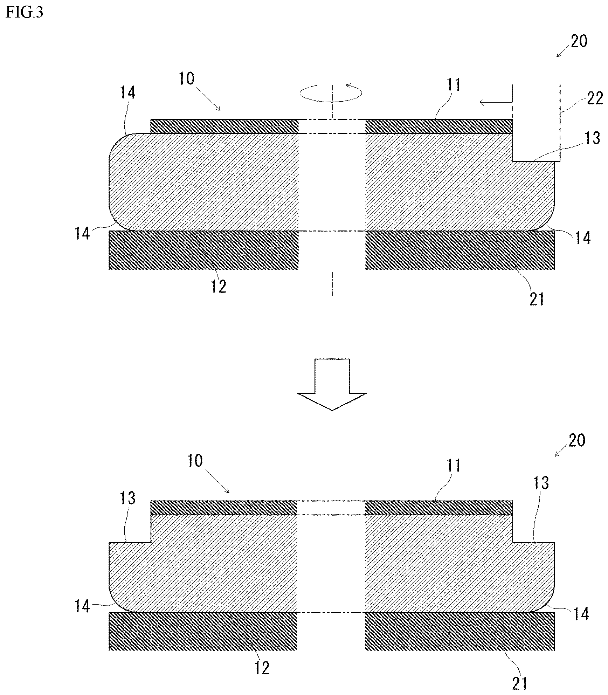

The semiconductor wafer 10 has an arcuate surface 14 at each portion from the non-ground surface 11 or the ground surface 12 to an outer surface by chamfering processing. In a trimming process, among the arcuate surfaces 14, the arcuate surface 14 on the non-ground surface 11 side is cut and removed (see Fig. 3). The trimmed semiconductor wafer 10 has the recessed level difference 13 on an outer peripheral edge of the non-ground surface 11 (see Fig. 2).

Here, the trimming process described above will be described.

As a trimming device 20 used in the trimming process, an apparatus including a chuck table 21 that sucks the semiconductor wafer 10 by vacuum suction and a trimming blade 22 as shown in Fig. 3 is exemplified.

During the trimming process, in the semiconductor wafer 10, the ground surface 12 is sucked to the chuck table 21 and fixed to the chuck table 21.

The trimming process is performed by pressing the trimming blade 22 against the outer peripheral edge of the non-ground surface 11 of the semiconductor wafer 10 while rotating the chuck table 21 to which the semiconductor wafer 10 is suck and fixed.

In the trimmed semiconductor wafer 10, the arcuate surface 14 on the non-ground surface 11 side is cut and removed by the trimming blade 22, whereby the recessed level difference 13 is formed on the outer peripheral edge of the non-ground surface 11.

In the level difference 13 due to the trimming process described above, a width W in a radial direction of the semiconductor wafer 10 is preferably 1 to 10 mm, more preferably 2 to 8 mm, and particularly preferably 3 to 7 mm (see Fig. 2).

The height H of the level difference 13 in the thickness direction of the semiconductor wafer 10 is preferably 10 to 100 µm, more preferably 20 to 80 µm, and particularly preferably 30 to 70 µm (see Fig. 2).

The level difference 13 is not limited to a level difference generated by the trimming process. Examples of the semiconductor wafer 10 having the level difference 13 on the outer peripheral edge of the non-ground surface 11 other than those obtained by the trimming process include the semiconductor wafer 10 having the following configuration.

In the semiconductor wafer 10 shown in Fig. 8, a plurality of the bumps 15 are formed on the non-ground surface 11, so that the level difference 13 is generated on the outer peripheral edge on the non-ground surface 11 side.

Although not particularly illustrated, examples of the semiconductor wafer having the level difference include a wafer in which a multilayer film is formed on the non-ground surface.

Regarding the level difference 13 described above, the width W and the height H are average values of actually measured widths and actually measured heights of the level differences at four points selected so as to be spaced at intervals of 10 to 90 degrees at the central angle, respectively.

In the present invention, the level difference 13 of the semiconductor wafer 10 includes a level difference due to the trimming process and a level difference due to formation of a bump and a multilayer film.

Specifically, it can be said that the level difference 13 due to the formation of a bump and a multilayer film has a height difference (height H in the thickness direction of the semiconductor wafer 10) of 10 to 300 µm within a range in which the width W in the radial direction of the semiconductor wafer 10 from the outer peripheral edge is 1 to 30 mm (see Fig. 8).

The semiconductor wafer 10 utilizing the protective film of the present invention may be of any type. As the semiconductor wafer 10, particularly, a wafer having a reduced sucking area with respect to a fixture such as a chuck table is useful.

Examples of the semiconductor wafer 10 having a reduced sucking area include, in particular, a trimmed wafer. In the trimmed semiconductor wafer 10, the outer peripheral edge of the non-ground surface 11 is trimmed (cut out), and the level difference 13 is provided, whereby the sucking area with respect to the fixture 41 (such as a chuck table) is reduced.

Here, the "sucking area" refers to an area where a sucking force obtained by the fixture 41 can act.

Specifically, the trimmed semiconductor wafer 10 has the level difference 13 formed by cutting out the outer peripheral edge of the non-ground surface 11 in a recessed shape. On the non-ground surface 11 of the semiconductor wafer 10, the level difference 13 and a portion other than the level difference 13 do not come into contact with the fixture 41 on the same surface. For this reason, the sucking force obtained by the fixture 41 hardly acts or does not act on the level difference 13.

Here, an actual sucking area ar1 on the non-ground surface 11 of the semiconductor wafer 10 is a value obtained by subtracting a plane area of a portion corresponding to the level difference 13 from a plane area ar2 of the semiconductor wafer 10 (see Fig. 2).

That is, in the semiconductor wafer 10 having the level difference 13 on the outer peripheral edge of the non-ground surface 11, the sucking force of the fixture 41 acts only on the sucking area ar1 smaller than the plane area ar2.

In other words, the semiconductor wafer 10 can be said to be a semiconductor wafer in which the sucking area ar1 of the non-ground surface 11 with respect to the fixture 41 is reduced from the plane area ar2 of the semiconductor wafer 10 (non-ground surface 11) by having the level difference 13 on the outer peripheral edge of the non-ground surface 11.

### [3] Back grinding method

A back grinding method for the semiconductor wafer according to the present invention includes a sticking step, a sucking step, and a grinding step.

The sticking step is a step of sticking the protective film to the surface of the semiconductor wafer on which the circuit is formed.

The sucking step is a step of sucking the semiconductor wafer to a fixture via the protective film interposed between the semiconductor wafer and the fixture sucking the semiconductor wafer.

The grinding step is a step of grinding the back surface of the semiconductor wafer in a state where the semiconductor wafer is sucked to the fixture via the protective film.

The protective film has a pressure-sensitive adhesive layer, a base material layer, and an auxiliary layer.

The pressure-sensitive adhesive layer is a layer stuck to the semiconductor wafer.

The auxiliary layer is a layer to be contact to the fixture.

The semiconductor wafer in the present invention is a semiconductor wafer having a level difference on an outer peripheral edge of the surface on which the circuit is formed. Since the semiconductor wafer having such a shape has the level difference on the outer peripheral edge, when the back surface is ground, a sucking area of the surface (on which the circuit is formed and to which the protective film is stuck) sucked to the fixture may be reduced as compared with the semiconductor wafer having no level difference on the outer peripheral edge.

Thus, since the semiconductor wafer in the present invention has the level difference on the outer peripheral edge of the surface on which the circuit is formed, the semiconductor wafer is a semiconductor wafer in which the sucking area of the surface (on which the circuit is formed) sucked to the fixture is reduced.

Specifically, the back grinding method is a method for reducing the thickness of the semiconductor wafer 10 by grinding the back surface of the semiconductor wafer 10.

The back grinding method is performed using a processing device 40 including the fixture 41 that sucks and fixes the semiconductor wafer 10 and a grinding tool 42 that grinds the ground surface 12 of the semiconductor wafer 10 as shown in Figs. 5 and 6.

In the back grinding method, the protective film 30 is used to protect the circuit formed on the non-ground surface 11 when the back surface of the semiconductor wafer 10 is ground.

As described above, the protective film 30 includes the base material layer 31, the auxiliary layer 32, and the pressure-sensitive adhesive layer 33.

As described above, the semiconductor wafer 10 has the level difference 13 on the outer peripheral edge of the non-ground surface 11 (the surface on which the circuit is formed), and the sucking area of the non-ground surface 11 with respect to the fixture 41 is reduced.

Hereinafter, each of the sticking step, the sucking step, and the grinding step will be described.

### (1) Sticking step

The sticking step is a step intended to stick the protective film 30 described above to the semiconductor wafer 10.

As shown in Fig. 4, in the sticking step, the protective film 30 is stick to the non-ground surface 11 of the semiconductor wafer 10.

In the sticking step, the protective film 30 is stuck to the non-ground surface 11 of the semiconductor wafer 10 so as to cover the uneven shape of the non-ground surface 11 of the semiconductor wafer 10, particularly, the level difference 13 of the outer peripheral portion.

In addition, a resin of an adhesive layer and the like can be interposed between the protective film 30 and the non-ground surface 11 of the semiconductor wafer 10. In this case, the non-ground surface 11 of the semiconductor wafer 10 can be more reliably protected by the interposed resin.

In the sticking step, the method and device for sticking the protective film 30 to the semiconductor wafer 10 are not particularly limited. Existing methods and devices can be used.

### (2) Sucking step

The sucking step is a step intended to suck the semiconductor wafer 10 to which the protective film 30 is stuck to the fixture 41.

Through this sucking step, the protective film 30 is interposed between the non-ground surface 11 of the semiconductor wafer 10 and the fixture 41 that sucks the semiconductor wafer 10, and the semiconductor wafer 10 is sucked to the fixture 41 via the protective film 30.

Specifically, as shown in Fig. 5, the semiconductor wafer 10 to which the protective film 30 is stuck in the sticking step is sucked to the fixture 41 such that the non-ground surface 11 faces the fixture 41 side.

In the auxiliary layer 32 of the protective film 30 in the sucking step, the surface layer portion on the fixture 41 side is elastically deformed following the surface shape of the fixture 41.

That is, the auxiliary layer 32 of the protective film 30 is elastically deformed so as to hold a sucking area ar3 with respect to the fixture 41 to be substantially the same size as an area ar4 of the surface of the fixture 41 without being affected by the surface shape of the non-ground surface 11, in particular, regardless of the sucking area ar1 which is uncertain due to the influence of variation of the level difference 13 and the like.

In other words, since the protective film 30 has the elastically deformable auxiliary layer 32, the sucking area ar3 that is reliably sucked to the fixture 41 can be held without being affected by the surface shape of the semiconductor wafer 10 such as the level difference 13.

For this reason, in the semiconductor wafer 10, since the protective film 30 has the auxiliary layer 32, occurrence of suction defect caused by the level difference 13 is suppressed.

Thus, the protective film 30 of the present invention is particularly useful in the back grinding method for the semiconductor wafer 10 having the level difference 13 generated by the trimming process.

### (3) Grinding step

The grinding step is a step intended to reduce the thickness of the semiconductor wafer 10 by grinding the ground surface 12 of the semiconductor wafer 10.

As shown in Fig. 6, in the grinding step, while the semiconductor wafer 10 is sucked to the fixture 41 in the sucking step described above, the grinding tool 42 is abutted against the ground surface 12.

In the processing device 40, the grinding tool 42 is configured to be rotatable about an axis extending in the thickness direction of the semiconductor wafer 10 as a rotation center, and is configured to be movable in the thickness direction of the semiconductor wafer 10. In the processing device 40, the fixture 41 is configured to be rotatable about the center thereof as an axis.

Then, while the grinding tool 42 and the fixture 41 are rotated, the grinding tool 42 moves to maintain a state in which the grinding tool 42 abuts against the ground surface 12, whereby the ground surface 12 is ground, and the semiconductor wafer 10 is reduced in thickness.

The present invention can also be used in back grinding of DBG or SDBG.

That is, as shown in Fig. 7, in the DBG and the SDBG, the semiconductor wafer 10 includes a plurality of half-cut portions 17 in the case of the DBG and a plurality of modified layers 17 in the case of the SDBG on the non-ground surface 11.

The semiconductor wafer 10 is reduced in thickness by grinding the ground surface 12 in a processing step, and is separated into a plurality of chips 10A and singulated in each half-cut portion 17 or each modified layer 17.

### EXAMPLES

Hereinafter, the present invention will be described specifically with reference to Examples.

### [Protective film]

As the protective film 30, a film for 12 inches was used.

The configuration of the protective film 30, the base material layer 31, and the auxiliary layer 32 are as follows.

### (1) Base material layer 31

Material: polyethylene terephthalate film, E'₃₁ (25): 4726 MPa, E'₃₁ (35): 4581 MPa.
Thickness: 50 µm.

### (2) Pressure-sensitive adhesive layer 33

Material: UV-curable acrylic adhesive
Thickness: 20 µm.

### (3) Auxiliary layer 32

### <Example 1>

Materials: ethylene-vinyl acetate copolymer (content of vinyl acetate: 19%), E'₃₂ (25): 21 MPa, E'₃₂ (35): 17 MPa.
Thickness: 120 µm.

### <Example 2>

Materials: ethylene-vinyl acetate copolymer (content of vinyl acetate: 9%), E'₃₂ (25): 40 MPa, E'₃₂ (35): 34 MPa.
Thickness: 120 µm.

### <Example 3>

Materials: ethylene-vinyl acetate copolymer (content of vinyl acetate: 9%), E'₃₂ (25): 40 MPa, E'₃₂ (35): 34 MPa.
Thickness: 160 µm.

### <Comparative Example 1>

The auxiliary layer 32 was not provided.

### [Semiconductor wafer]

As the semiconductor wafer 10 provided with the circuit, the following was used.

### (1) Dimension

Diameter: 300 mm.
Thickness: 810 µm.
Material: silicon.

### (2) Level difference 13

The trimming process was performed with the width W set to 5 mm and the height H set to 50 µm to form the level difference 13 (see Fig. 2).

### [Back grinding method]

### (1) Sticking step

A tape sticking machine (product number "DR -3000 II" manufactured by Nitto Seiki Co., Ltd.) was prepared, and the protective film 30 was stuck to the non-ground surface 11 of the semiconductor wafer 10, and an extra portion was cut off to obtain samples of Examples 1 to 3 and Comparative Example 1.

### (2) Sucking step

A processing device (product number "DGP 8760" manufactured by DISCO Corporation) was prepared, the samples of Examples 1 to 3 and Comparative Example 1 were sucked to the fixture 41, and the presence or absence of suction defect was observed.

For this observation, each sample was sucked to the fixture 41 three times, and the number of times of occurrence of suction defect was measured.

As a result of the observation, in Examples 1 to 3, no suction defect occurred.

On the other hand, in Comparative Example 1, the suction defect occurred in all three times of suction.

From the above results, it was shown that the suction defect could be prevented by the protective film 30 having the auxiliary layer 32.

### (3) Grinding step

In (2) Sucking step, no suction defect occurred. For Examples 1 to 3, the grinding step was performed using the processing device described above.

In this grinding step, three sheets of each sample were subjected to back grinding, and the number of defects such as wafer cracking was measured.

As a result, in Examples 1 to 3, defects such as wafer cracking did not occur.

From the above results, it was shown that occurrence of defects such as wafer cracking during the grinding step could be prevented by the protective film 30 having the auxiliary layer 32.

### INDUSTRIAL APPLICABILITY

The protective film of the present invention is widely used in applications for manufacturing a semiconductor component. In particular, since a semiconductor wafer having a level difference on an outer peripheral edge has a characteristic capable of suitably suppressing suction defect to a fixture, the semiconductor wafer is suitably used for manufacturing a component excellent in productivity.

### REFERENCE SIGNS LIST

- 10;: semiconductor wafer
- 11;: non-ground surface (surface on which circuit is formed)
- 12;: ground surface
- 13;: level difference
- 14;: arcuate surface
- 15;: bump
- 17;: half-cut portion or modified layer
- 20;: trimming device
- 21;: chuck table
- 22;: trimming blade
- 30;: protective film
- 31;: base material layer
- 32;: auxiliary layer
- 33;: pressure-sensitive adhesive layer
- 40;: processing device
- 41;: fixture
- 42;: grinding tool

## Claims

1. A protective film that protects a surface of a semiconductor wafer on which a circuit is formed when a back surface of the semiconductor wafer is ground in a state where the surface of the semiconductor wafer on which the circuit is formed is sucked to a fixture, the protective film comprising:
a pressure-sensitive adhesive layer; a base material layer; and an auxiliary layer,
wherein the pressure-sensitive adhesive layer is a layer to be stuck to the semiconductor wafer,
the auxiliary layer is a layer to be contact to the fixture, and
the semiconductor wafer has a level difference on an outer peripheral edge of the surface on which the circuit is formed.

2. The protective film according to claim 1, wherein the auxiliary layer is a layer having a tensile elastic modulus of 10 MPa or more and 200 MPa or less at a temperature of 25°C or higher and 35°C or lower.

3. The protective film according to claim 1 or 2, wherein the auxiliary layer contains one or more than one selected from the group consisting of an ethylene-vinyl acetate copolymer, a polyolefin-based elastomer, a styrene-based elastomer, a polyester-based elastomer, and a polyamide-based elastomer.

4. The protective film according to any one of claims 1 to 3, wherein a thickness of the auxiliary layer is 100 µm or more and 500 µm or less.

5. The protective film according to any one of claims 1 to 4, wherein the base material layer is a layer having a tensile elastic modulus of 5000 MPa or less at a temperature of 25°C or higher and 35°C or lower.

6. The protective film according to any one of claims 1 to 5, wherein the base material layer contains one or more than one selected from the group consisting of polyester and polyamide.

7. The protective film according to any one of claims 1 to 6, wherein a thickness of the base material layer is 10 µm or more and 200 µm or less.

8. Aback grinding method for a semiconductor wafer, the method comprising:
a sticking step of sticking a protective film to a surface of a semiconductor wafer on which a circuit is formed;
a sucking step of sucking the semiconductor wafer to the fixture via the protective film, with the protective film interposed between the semiconductor wafer and the fixture sucking the semiconductor wafer; and
a grinding step of grinding a back surface of the semiconductor wafer in a state where the semiconductor wafer is sucked to the fixture via the protective film,
wherein the protective film includes a pressure-sensitive adhesive layer, a base material layer, and an auxiliary layer,
the pressure-sensitive adhesive layer is a layer to be stuck to the semiconductor wafer,
the auxiliary layer is a layer to be contact to the fixture, and
the semiconductor wafer has a level difference on an outer peripheral edge of the surface on which the circuit is formed.

9. The back grinding method for a semiconductor wafer according to claim 8, wherein the auxiliary layer is a layer having a tensile elastic modulus of 10 MPa or more and 200 MPa or less at a temperature of 25°C or higher and 35°C or lower.

10. The back grinding method for a semiconductor wafer according to claim 8 or 9, wherein the auxiliary layer contains one or more than one selected from the group consisting of an ethylene-vinyl acetate copolymer, a polyolefin-based elastomer, a styrene-based elastomer, a polyester-based elastomer, and a polyamide-based elastomer.

11. The back grinding method for a semiconductor wafer according to any one of claims 8 to 10, wherein a thickness of the auxiliary layer is 100 µm or more and 500 µm or less.

12. The back grinding method for a semiconductor wafer according to any one of claims 8 to 11, wherein the base material layer is a layer having a tensile elastic modulus of 5000 MPa or less at a temperature of 25°C or higher and 35°C or lower.

13. The back grinding method for a semiconductor wafer according to any one of claims 8 to 12, wherein the base material layer contains one or more than one selected from the group consisting of polyester and polyamide.

14. The back grinding method for a semiconductor wafer according to any one of claims 8 to 13, wherein a thickness of the base material layer is 10 µm or more and 200 µm or less.
